# EUROPEAN PATENT APPLICATION

(11) **EP 1 246 328 A2**
(43) Date of publication of application: **02.10.2002**
(21) Application number: 02000400.8
(22) Date of filing: 07.01.2002
(51) Int. Cl.: H01S 5/183

(54) **Intracavity contacted long wavelength VCSELs with buried antimony layers**

(30) Priority: 15.03.2001 US 810111
(71) Applicant: Agilent Technologies, Inc. (a Delaware corporation), Palo Alto, CA 94303 (US)
(72) Inventor: Lin, Chao-Kun, Palo Alto, California 94304 (US); Corzine, Scott W., Palo Alto, California 94304 (US); Tan, Michael R. T., Palo Alto, California 94304 (US); Houng, Yu-Min, Cupertino, California 95014 (US)
(74) Representative: Liesegang, Eva

(57) **Abstract**

A vertical cavity surface-emitting laser (400, 500), and method of fabricating such a laser, for use in an optical communication system (100) including an optical cavity (223, 323) arranged between a pair of distributed Bragg reflectors (402/404, 502/504), an active region (217) in the optical cavity, and an oxidized current confinement layer (215, 315) arranged on one side of the active layer. The current confinement layer includes a component, such as antimony, that is segregated into a conductive layer on one side (221, 321) of the current confinement layer during oxidation.

## Description

### TECHNICAL FIELD

The present disclosure generally relates to coherent light generation where the active media is a semiconductor material under stimulated emission with a particular confinement layer. More particularly, the disclosure relates to vertical cavity surface-emitting lasers with buried antimony layers for use in optical communication systems.

### BACKGROUND OF THE INVENTION

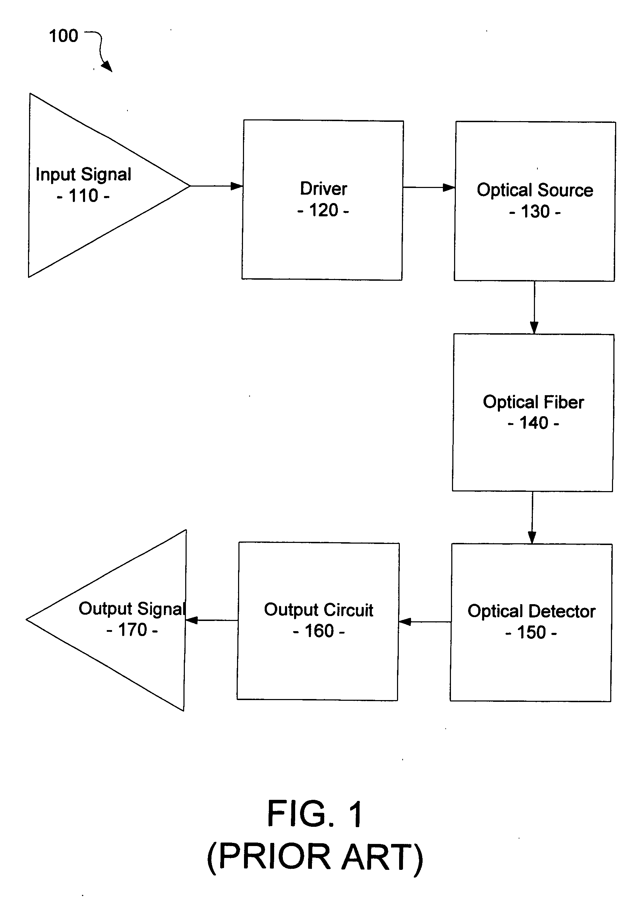

Optical communication systems are now commonly-used for exchanging information via light wave signals. FIG. 1 is a conceptual block diagram for an optical "fiber" communication system 100 in which an input signal 110 is provided to a driver 120 that controls an optical source 130. Light waves from the optical source 130 are then transmitted over an optical fiber, or other "waveguide," 140 for reception by an optical detector 150 and an output circuit 160 that produces an output signal 170.

The performance of these, so-called "fiber-optic," communication systems is generally limited by the "attenuation" and "dispersion" of the optical fiber waveguide 140. Attenuation, or fiber loss, refers to a decrease in the optical power of the transmitted signal that is caused by "absorption" (conversion to heat), "scattering" (ejection from the core of the waveguide), and other extrinsic effects. Dispersion, on the other hand, refers to the spreading of optical pulses into longer time intervals that limit the rate at which data can be transmitted through the waveguide. These and other aspects of fiber-optic transmission are discussed in Freeman, Practical Data Communication, Section 10.2 (John Wiley & Sons 1995) which is incorporated by reference here.

At certain wavelengths of transmitted light, the dispersion approaches zero for conventional fused-silica, single mode fibers. Although the exact wavelength at which this phenomenon occurs is a function of the core diameter and refractive index profile of the waveguide 604, the range typically extends from a wavelength of about 1300 nanometers ("nm") for a 10-micron core to about 1600 nm (1.6 micrometers "µm") for a 4-micron core. Fortunately, attenuation is also minimized for a wavelength range, or "band," of around 1300 nm and 1500 nm. Consequently, for many optical communications systems in use today, it is desirable to have an optical source 630 that produces light in a single, relatively-long wavelength, on the order of approximately 1300-1550 nm in order to minimize dispersion and attenuation. Since the wavelength and frequency of light waves are related by their speed of propagation, wavelengths are often expressed in terms of an equivalent frequency. Additional information concerning laser sources for optical communication systems is available in Senior, Optical Communication Systems, pp. 281-373 (Prentice Hall, 2d ed 1992) which is also incorporated by reference here.

Due to the narrow "spectral linewidth" (or range of wavelengths) at which they produce light, fast modulation rates, and other features, laser diodes or "semiconductor lasers" are often the preferred optical source 130 for a fiber-optic communication system 100. However, such relatively-long wavelength semiconductor lasers are also useful in a variety of other applications. Such lasers generally include an "optical cavity" with an "active region" arranged between two "reflectors." Light from the active region bounces back and forth between these reflectors, gaining intensity with each pass, until a portion of the light is allowed to escape the oscillator cavity. So-called "edge-emitting" lasers produce light from between the layers of the structure, substantially parallel to the active region, while "surface-emitting" lasers emit light substantially perpendicular to the layers forming the active region.

In vertical cavity surface-emitting lasers, or "VCSELs," the optical cavity is typically arranged between two "distributed Bragg reflectors," or "DBRs." In simple terms, each of these DBRs consists of alternating layers of materials where each layer is partially reflective and has a different "refractive index." This refractive index "contrast" causes a change in the direction of propagation of the light through the partially reflective layer depending upon its wavelength (or color, for visible wavelengths of light). Consequently, DBRs act essentially as a wavelength-selective, or filtering, reflectors for returning light in only a small range of wavelengths. The optimum reflectivity for a DBR generally occurs where the thickness of the layers is multiple of one quarter of the wavelength of the lightwave.

The semiconductor materials that are used for DBRs, and other components of semiconductor lasers, laser must fulfill a variety of criteria. For example, different materials must be "lattice-matched" so as to have essentially the same crystalline structures in order to grow, deposit, or otherwise form "epitaxial" layers on a bottom "substrate" layer. Furthermore, in order to emit coherent light at an appropriately narrow range of wavelengths, the materials must have a corresponding "bandgap energy" for which a photon will dislodge an electron from the semiconductor material as discussed in more detail below.

Quaternary (*i.e.*, four-component) semiconductor alloys are often preferred for achieving the appropriate bandgap energy and lattice parameter. The most well-developed of these semiconductor material systems for producing stimulated emission in the 1.3-1.55 µm wavelength band include Indium Gallium Arsenide Phosphide semiconductor alloys ("In₁₋ₓGaₓAs_{y}P_{1-y}" where X and Y are percentage in decimal format, or more simply, "InGaAsP") that are lattice-matched to Indium Phosphide ("InP"). So-called "InGaAsP/InP" lasers have proven to be quite reliable in the edge-emitting configurations that are now widely-used in telecommunication systems.

However, these materials have not yet found wide in vertical cavity surface-emitting lasers due to the limitations of conventional InP lattice-matched DBRs. For example, InGaAsP/InP and AlInGaAs/AlInGaAs DBRs have a refractive index contrast of just 0.27 and 0.29 at 1.55 µm, respectively. Consequently, more than 41 DBR layer pairs are required in order to achieve a high reflectivity of around 99%. The total thickness of this many reflector pairs would exceed 10 µm, making them impractical to manufacture. Furthermore, the stop bandwith of lasers including such DBRs would be less than 100 nm, making them extremely difficult to tune.

Nonetheless, the possibility of on-wafer testing, two-dimensional array formation, integration with other electronic devices, and correspondingly lower production costs has led researchers to look material combinations that will provide relatively-long wavelength VCSELS with less DBR layers. For example, one such VCSEL is disclosed in European Patent Publication No. 1,026,798 (applied for by Agilent Technologies, Inc.) claiming priority to U.S. Patent Application No. 243,184 (filed February 2, 1999), both of which are incorporated by reference into this document.

EP 1,026,798 describes a VCSEL with a 5-20 layer SiO₂/TiO₂ distributed Bragg reflector that is buried within a substrate layer of indium phosphide. The device also includes a current confining layer that is formed using a dielectric material such as silicon dioxide ("SiO₂"), silicon nitride ("SiN"), carbonized organic material, silicon carbide ("SiC"), or a non-dielectric material, such as a high-bandgap semiconductor material. The current confinement layer creates a current path through the active layer between the contacts so as to generate light in the active layer that is emitted from one of the DBRs as a single frequency output.

EP 1,026,798 further discloses that the current confining layer may be replaced with ion implantation regions in the layer adjacent to the Bragg reflector. In particular, these ion implantation regions may be formed by implanting hydrogen, oxygen, helium, and iron ions as known by those skilled in the art. Furthermore, the Bragg reflectors may use a gallium arsenide ("GaAs") material system that is joined to an indium phosphide substrate by wafer bonding. However, this latter method is disfavored due to poor electrical conductivity across the bonded interface and the requirement for joining the material systems using costly wafer bonding processes. It is also disclosed that long wavelength lasers may be created without wafer bonding using an active layer of gallium arsenide nitride ("GaAsN") or gallium arsenide phosphide antimonide ("GaAsPSb"). However, the growth of these active layers is described as being difficult, costly, and time-consuming.

D.I. Babic *et al.*, "IEEEphotonic Technology Letter," Vol. 7, No. 11, 1995, pp. 1225-1227 (November 1999), also incorporated by reference here, discloses a double-fused, electrically-pumped VCSEL operating at 1.54 µm in which AlGaAs-based DBRs are integrated with an InP-based active region using wafer fusion or wafer bonding technology. There are two separate wafer fusion steps involved in the device fabrication. Both the top and bottom DBRs are electrically conductive, and the carriers must flow through the fused interface before recombining in the active region. However, the p-type InP/GaAs fused junction exhibits non-ohmic behavior and a high voltage drop that increases power dissipation and limits the performance of the device.

V. Jayaraman *et al.*, Electronics Letter, Vol. 34, No. 14, 1998, pp. 1405-1407 (July 1998), also incorporated by reference here, discloses a double-fused, optically-pumped 1.3 µm VCSELs in which the InP-based active region is fused onto a short wavelength (850 run) pump VCSEL. Since the heat generated in the pump VCSEL does not affect the InP-based active region, the devices exhibit good performance for operation up to 70°C, and the maximum output power exceeds 1 mW at room temperature. However, the fabrication of this device involves 3 different growths and two wafer fusion processes, which is not very appealing for mass production.

J. Boucart *et al.*, IEEE Journal of Selected Topics in Quantum Electronics, Vol. 5, No. 3, 1999, pp. 520-529 (May/June 1999), also incorporated by reference here, discloses a "metamorphic" DBR VCSEL in which the lattice-matched DBR and active region are first grown on InP-substrate. A highly lattice-mismatched (~20%) AlAs/GaAs DBR is then grown on top of the InP-based structure. Although reasonable device performance has been demonstrated, the reliability of this device is a concern due to defects in the AlGaAs DBR propagating back into the active region.

M. Kondow *et al.*, IEEE Journal of Selected Topics in Quantum Electronics, Vol. 3, No. 3, 1997, pp. 719-730, (June 1997), also incorporated by reference here, discloses a GaInNAs/GaAs lattice-matched monolithic VCSEL. M. Yamada *et al.*, IEEE Photonics Technology Letters, Vol. 12, No. 7, 2000, pp. 774- 776 (July 2000), also incorporated by reference here, discloses GaAsSb edge-emitting lasers grown on GaAs substrates. O. Blum *et al.*, Applied Physics Letters, Vol. 67, No. 27, 1995, pp. 3233-3235 (November 1995) discloses an AlAsSb/GaAsSb DBR that is grown by molecular beam epitaxy ("MBE").

Bandgap can be used to help distinguish between metals, non-metals, semiconductors, and so-called "semimetals." In simple terms, every solid contains electrons that exist in only certain discrete bands of energy that can be thought of as being separated by gaps. The lower-energy "valence band" must contain a minimum number of electrons before any electrons will move into a higher-energy "conduction band" where they are free to move between atoms. The difference between the lowest and highest "edges" of the conduction and valence bands, respectively, defines the energy bandgap discussed above.

"Metals," such as copper and gold, have full valence bands and partially-filled conduction bands at normal temperatures. The availability of unoccupied states in the conduction band means that electrons can move about metallic solids relatively easily, making them good conductors of electricity. However, the resistivity of conductors tends to fall rapidly with temperature. Non-metals, or "insulators," on the other hand, have full valence bands and empty conduction bands that are separated by a wide energy gap at normal temperatures. Consequently, the valance electrons in non-metals will move into the conduction band only at very high energy levels (*e.g.* at high voltages). Furthermore, the resistance of an insulator typically rises as its temperature decreases.

"Semiconductors" generally have a full valence band and an empty conduction band that are separated by a narrow energy gap. Consequently, they act as insulators at very low energy levels, but their conductivity quickly increases with temperature as the charge carriers move from the valence band into the conduction band. The electrical properties of "extrinsic" semiconductor materials can also be manipulated by varying the type and amount of (p- and n-type) dopants used to form (positive and negative) charge carriers in their lattice structure.

For "semimetals," the conduction band edge is slightly lower in energy than the valance band edge so that the bands overlap and create a negative bandgap energy. This typically leads to a small concentration of positive charge carriers (or "holes") in the valence band and of electrons in the conduction band. Like semiconductors, semimetals can be doped with suitable impurities in order to vary the relative concentrations of charge carriers. Furthermore, the overlap of the valence and conduction band edges may also vary with pressure. Such semimetal materials typically include arsenic ("As"), antimony ("Sb"), bismuth ("Bi"), carbon ("C") graphite, mercury telluride ("HgTe"), and other materials. Semimetals have also been characterized as having conduction electron concentrations of 10¹⁷ and 10²² per cubic centimeter in C. Kittell, Introduction to Solid State Physics, pp. 185-250 (5th ed. 1976) which is also incorporated by reference here.

The efficiency and maximum output power of VCSELs, and other lasers, largely depends on certain internal energy losses that are related to "absorption" of photons that would otherwise be emitted. Absorption can be thought of as the loss of light as it passes through a material, generally due to its conversion to other energy forms, such as heat. Several processes can lead to the absorption of photons as discussed in Saleh *et al.*, Fundamentals of Photonics, pp. 573-591 (1991), also incorporated by reference here. One such process is "free-carrier," or "intraband," absorption whereby an electron absorbs a photon by moving from a low-energy level to a higher-energy level in the same band. This is followed by "thermalization" whereby the electron relaxes down to the lowest energy level in the conduction band while releasing its energy in the form of "lattice vibrations," or heat.

Free-carrier and other types of absorption are far more pronounced in long-wavelength lasers than their short-wavelength counterparts. For example, the free-carrier absorption coefficient for p-type GaAs at 980 nm is ~7 cm⁻¹ for a hole concentration of 10¹⁸ cm⁻³, while that for 1300 nm and 1550 nm are 15 cm⁻¹ and 29 cm⁻¹, respectively. Until now, the prior art has generally failed to appreciate the significance of free-carrier absorption in long-wavelength semiconductor lasers. More particularly, the prior art has failed to suggest any approach for reducing free-carrier absorption losses in long-wavelength VCSELs so as to provide more efficient and/or powerful lasers.

### SUMMARY OF THE DISCLOSURE

These and other drawbacks of conventional technology are addressed here by providing a long-wavelength VCSEL, and method of fabricating such a VCSEL, having reduced resistance, reduced free-carrier absorption, and other features that are useful in a variety of applications, including optical communication systems.

In one embodiment, the laser includes an optical cavity arranged between a pair of distributed Bragg reflectors. The optical cavity includes an active region, and a current confinement layer arranged on one side of the active layer. The current confinement layer includes a segregated component that is electrically conductive. The segregated component of the current confinement layer may include a conductive semimetal element, such as antimony, or a conductive semimetal alloy that includes antimony. The semimetal material is preferably segregated into a layer on one side of the current confinement layer.

The current confinement layer preferably includes a non-conductive portion, such as an oxidized portion, that defines the edges of a non-oxidized current aperture. The segregated component is then preferably formed on one side of the oxidized portion of the current confinement layer. For example, the current confinement layer may include, and preferably consists essentially of, AlGaAsSb. The Al composition of the current confinement layer is also preferably greater than 90% in order to facilitate the oxidation process. The oxidized portion of such a current confinement layer will include a segregated antimony layer on one side depending upon the stresses that are placed on the device during oxidation.

In another embodiment, the laser includes an InP substrate, and an optical cavity positioned over the substrate and between two distributed Bragg reflectors. The distributed Bragg reflectors are formed from alternating layers including, and preferably consisting essentially of, AlGaAsSb and AlAsSb semiconductor materials. The InP substrate is preferably adjacent to a first AlGaAsSb layer of one of said Bragg reflectors that has less than 41, and preferably less than 31 pairs of layers. The optical cavity may include outer contact layers comprising, and preferably consisting essentially of, InP semiconductor material.

In yet another embodiment, a method of fabricating a VCSEL on an InP substrate is provided where a first distributed Bragg reflector is formed (grown, deposited, sprayed, *etc.)* on the substrate with alternating layers consisting essentially of AlGaAsSb and AlAsSb, respectively. A first contact layer consisting essentially of InP is formed on the uppermost layer of the first distributed Bragg reflector and a first spacer layer is formed on the first contact layer. An active region is then formed on the first spacer layer, and a second spacer layer is formed on the active region.

A current confinement layer is then formed on the second spacer layer, preferably consisting essentially of an AlGaAsSb alloy having at least 90% aluminum. The edges of the current confinement layer are exposed and the device is oxidized, preferably in a wet-oxidation process, for a limited period of time. Oxidation produces highly-resistive portion near the edges and an unoxidized, and a conductive aperture near the center of the current confinement layer. Oxidation also segregates a conductive layer including, and preferably consisting essentially of, antimony on one side of the current-confinement layer. A second contact layer consisting essentially of InP is then formed on the second spacer layer, and a second distributed Bragg reflector is formed on the second contact layer.

In still another embodiment, the inventor relates to an optical communication system, such as a fiber-optic communication system, including such a VCSEL. A variety of other devices, methods, systems, and features of the present invention will become apparent to those having ordinary skill in this art upon examination of the following drawings and written description.

### BRIEF DESCRIPTION OF THE DRAWINGS

Various aspects of the invention will now be described with reference to the attached drawings where the illustrated components are not necessarily drawn to scale, but the same reference numerals are used consistently throughout the Figures in order to identify the same features, and
FIG. 1 is a block diagram of a conventional optical communication system;
FIG. 2 is a cross-sectional view of an optical cavity for an improved VCSEL;
FIG. 3 is a cross-sectional view of another optical cavity for an improved VCSEL;
FIG. 4 is a cross-sectional view of a single intracavity VCSEL including the optical cavity shown in FIG. 2; and
FIG. 5 is cross-sectional view of a double intracavity VCSEL including the optical cavity in FIG. 3.

### DETAILED DESCRIPTION OF THE PREFERRED EMBODIMENTS

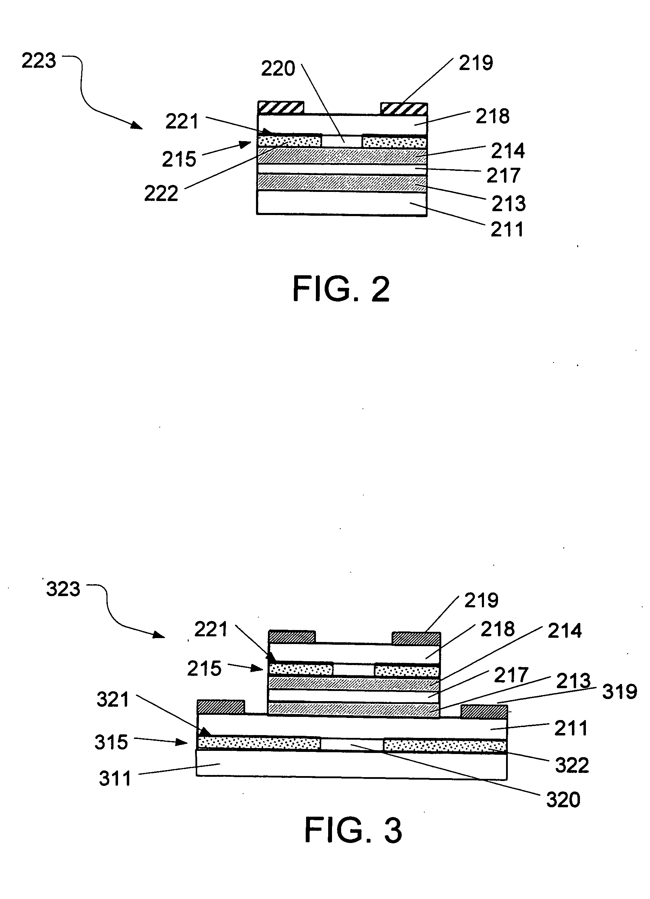

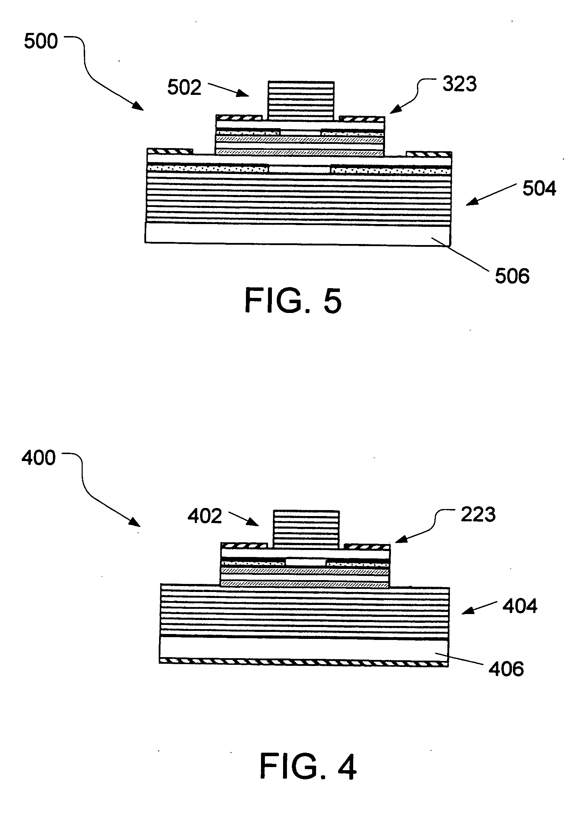

FIG. 2 is a cross-sectional view of an optical cavity 223 for use with the single intracavity VCSEL 400 shown in cross-section in FIG. 4. FIG. 3 is a cross-sectional view of an optical cavity 323 for use with the double intracavity VCSEL 500 shown in cross-section in FIG. 5. However, the optical cavities 223 and 323 may also be adopted for use with other semiconductor lasers and/or diodes besides those shown in FIGS. 4 and 5.

In FIG. 2, the optical cavity 223 includes several epitaxial layers that are grown, deposited, and/or otherwise formed on an indium phosphide contact layer 211 using conventional semiconductor fabrication techniques, such as MBE, MOCVD, and/or others. However, other materials besides InP may also be used. The optical cavity 223 has an active region 217 that is arranged between lower and upper spacer layers 213 and 214, respectively. However, the active region may also be formed by a simple heterojunction between two adjacent layers.

A current confinement layer 215 is arranged over the second spacer layer 214. Lower and upper contact layers 211 and 218, respectively, are arranged on each side of the heterostructure formed by layers 213, 214, 215 and 217. An ohmic (metal) contact 219 is arranged on the upper contact layer 218. The contact layers 211 and 218 are preferably formed from a semiconductor material including indium phosphide, and preferably consisting essentially of indium phosphide, due to its favorable high thermal conductivity. However, a variety of other appropriately lattice-matched, or nearly lattice-matched, materials may also be used for the contact layers 211 and 218. The upper contact layer 211 is preferably doped to form a p-type semiconductor while the lower layer preferably is doped to form an n-type semiconductor.

The active region 217 preferably includes multiple quantum-well structures including, or consisting essentially of, an InAsP/AlInGaAs, InGaAsP/InGaAsP, or AlInGaAs/AlInGaAs material system. However, other appropriately lattice-matched materials, and other structures besides quantum wells, may also be used. For these materials in the active region 217, the spacer layers 213 and 214 preferably include, or consist essentially of, InGaAsP, AlGaAsSb, InP, and/or other appropriately lattice-matched materials depending upon which material is chosen for the active region 217.

The current confinement layer 215 preferably has an aluminum composition that is at least 80%, and preferably greater than 90%, in order to facilitate oxidation, as discussed below. This high aluminum composition allows the current confinement layer 215 to be oxidized in a saturated steam environment at atmospheric pressure and a moderate temperature of around 350-400 C. Such "wet-oxidation" processes are generally similar to those applied to conventional AlGaAs layers in short-wavelength VCSELs. However, a variety of other oxidation temperatures, pressures, and/or processes, and other aluminum concentrations, may also be used. In general terms, lower aluminum concentrations will require more energy-intensive (and therefore more costly and/or dangerous) oxidation techniques, and *vice-versa*.

Prior to oxidation, a pillar (or mesa) is etched into the multilayer structure so as to expose the edges of the current confinement layer 215. This etched structure is then subjected to the oxidizing environment, and the layer 215 starts to oxidize from its exposed edges toward the middle of the pillar. The other layers are not significantly affected by the oxidation process. By limiting the oxidation time, a central portion of the oxidation layer 215 will remain unoxidized. Consequently, the current confinement layer 215 will be partially oxidized to form an outer highly-resistive oxide portion 222 surrounding an inner (unoxidized) conductive portion 220 referred to as a "current aperture."

In addition to formation of the current aperture 220, oxidation of the current confinement layer 215 has been found to segregate one or more component materials. These materials are preferably segregated from the alloy components of the layer 215. The particular wet-oxidation processes described above, for example, has been found to adequately segregate a component material from a layer 215 that consists essentially of AlGaAsSb when the aluminum composition of the alloy is sufficiently high. This segregated material preferably forms a conductive, semimetal layer 221 on one side of the oxide layer 215. The segregated layer 221 is preferably be formed either above or below the AlGaAsSb oxide layer 215, depending on the strain around the layer 215 during the oxidation process.

Other conductive materials besides semimetals, including less-conductive or more-conductive materials, may also be segregated from the oxide layer 215 depending upon its alloy composition. However, the current confinement layer 215 is preferably formed from component elements that require different amounts of energy in order to form oxides. The component elements should also have different atomic sizes so as to preferentially segregate from each other during oxidation. For example, in AlAsSb alloys, the energy that is required to form aluminum oxides is lower than that required to form antimony oxides or arsenic oxides. In addition, the antimony atom is relatively large so that it cannot easily leave the host crystal and become segregated from the other component elements in order to form the conductive layer 221.

For the preferred AlGaAsSb (>90% Al) material system and wet-oxidation process discussed above, the segregated layer 221 was analyzed using Auger electron spectroscopy and found to consist essentially of antimony. The antimony layer 221 was found to have a fairly high electrical conductivity of around 39.1 micro ohms-cm and forms an ohmic contact between layers in the optical cavity 223.

Some gallium, aluminum, arsenic, and/or other impurities may also be present in the segregated layer 221. However, it is expected that with sufficient quality control, an AlGaAsSb current confinement layer 215 can be wet-oxidized to remove most of the arsenic, leaving behind a substantially-oxidized portion without antimony 222 with an elemental antimony layer 221 defining an unoxidized aperture 220. Furthermore, it is expected that other conductive materials (including non-metal, metal, semimetal and/or semiconductor materials with or without antimony) could be segregated in a similar manner from a variety of other alloys (including semiconductor alloys, semimetal alloys, or a combination thereof) during various oxidation processes, including, for example, wet-oxidation processes.

Due to the segregation of the conductive layer 221 from the oxide portion 222 of the current confinement layer 215, the total resistance to lateral current conduction through optical cavities 223, 323 can be greatly reduced without increasing the doping level of the neighboring indium phosphide contact layer 218. Since lower doping levels (*e.g.*, 1-5E17 cm-3) can be used inside the optical cavity 223, the number of free-carriers and the losses associated with free-carrier absorption are also reduced, thus providing a more efficient laser. This latter effect is particularly pronounced for p-type layers. Consequently, the AlGaAsSb current confinement layer 215 is preferably inserted on the p-side of the optical cavity 223, as shown in FIG. 2, so as to reduce the amount of p-type doping that would otherwise be required.

Since the segregated layer 221 is absorptive for optical field within the cavity 223, it is preferably placed at the null of the standing wave pattern formed inside the cavity so as to minimize optical losses. However, if a less-absorptive material is provided for the layer 221, or if single mode devices are of interest, then the antimony layer 221 may be arranged at other positions. For example, the antimony layer 221 can be positioned to increase optical losses for higher-order modes and suppress them from lasing.

FIG. 3 shows an optical cavity 323 (for a double intracavity VCSEL) that includes many of the same features of the optical cavity 223 (for a single intracavity VCSEL) shown in FIG. 2. In FIG. 3, a second AlGaAsSb current confinement layer 315 is inserted on the n-side of the cavity 323 and provided with another oxide layer 322 to form an aperture 320. The second current confinement layer 315 also includes another thin conductive layer 321, preferably consisting essentially of antimony and/or other components that are segregated during wet oxidation. The aluminum composition of this second n-type AlGaAsSb layer 315 is preferably larger than that of the p-AlGaAsSb layer 215 so that a larger oxide portion 322 may be obtained on the n-layer (and the same size apertures 220 and 320) when both layers are oxidized simultaneously. A second ohmic contact 319 is provided on the mesa of the contact layer 211 and another InP layer 311 is also arranged under the current confinement layer 315.

FIGS. 4 and 5 illustrate VCSELs, including the optical cavities 223 and 323 shown in FIGS. 2 and 3, respectively. In FIGS. 4 and 5, the VCSELs 400 and 500 are provided with upper and lower distributed Bragg reflectors 402, 404 and 502, 504, respectively. The distributed Bragg reflectors in FIGS. 4 and 5 contain alternating layers of different semiconductor materials including, and preferably consisting essentially of, AlGaAsSb and AlAsSb. However, other materials that are properly lattice-matched to InP may also be used. The refractive index difference between these layers is about 0.4 to 0.5. Consequently, a reflectivity of 99.9% can be easily achieved with just 30 pairs of layers in each stack of layers. This latter feature results in a reduction of the size and fabrication time for the VCSELs 400 and 500 as compared to conventional VCSELs formed on InP substrates with conventional distributed Bragg reflectors that require more layers.

With the single intracavity design shown in FIG 4, the bottom distributed Bragg reflector 404 must be conductive and is preferably doped as n-type. This free-carrier absorption losses that come from doping the distributed Bragg reflector 404 can be avoided using an undoped distributed Bragg reflector 504 with the double intracavity design shown in FIG. 5.

The present inventors have also noted that the thermal conductivity of the AlGaAsSb alloy in the optical cavities 223, 323 and DBRs 402, 404 and 502, 504 is typically fairly low, around 0.0158-0.02 W/cm-K. Consequently, the performance of these devices can be significantly degraded by the increase in temperature due to a buildup of thermal energy in the AlGaAsSb layers during normal operation. However, it has also been found that the use of complicated and expensive, conventional "heat sinking" technology to remove this excess heat can be avoided by providing relatively thick InP contact layers 211, 218 in the cavity. Heat can also be dissipated more efficiently by replacing the low-index AlGaAsSb layer of the reflector stacks 404 and 504 with InP layer so as to improve the thermal conductivity of the DBR in directions perpendicular and parallel to the DBR stacks from 0.018 and 0.0327 to 0.0185 and 0.367, respectively.

As noted above, FIG. 1 is a block diagram of a conventional optical communication system. The cost and performance of such conventional systems can be improved by providing a VCSEL 400 or 500 for the optical source 130. The VCSEL 400 or 500 with provide light at the appropriately long wavelength without suffering from the free-carrier, size, and/or tuning problems associated with conventional optical sources for these and other applications.

These and other advantages are provided by the technology disclosed above. For example, the technology is relatively easy to implement since the physics of semiconductor lasers having InP-based active regions (including InGaAsP, AlInGaAs, InAsP, and others) is well-understood. Furthermore, since the AlGaAsSb-based distributed Brag reflector is lattice-matched to the InP substrate, the entire VCSEL structure can also be grown with a single epitaxial growth, making it less-complicated and less-expensive to produce. The segregated antimony layer improves lateral current conduction dramatically and allows the device to operate more efficiently and/or with lower doping levels of the nearby semiconductor layers. In fact, the double intracavity configuration essentially eliminates free-carriers in the distributed Brag reflectors and their associated optical losses.

It should be emphasized that the embodiments of the present invention that are described above, and particularly any "preferred" embodiments, are merely examples of various implementations that are used here to describe the basic principles of the invention. Many structural and functional variations may be made to these embodiments without departing from the scope of the invention that is defined by the following claims when they are properly construed and interpreted in light of the preceding description.

## Claims

1. A vertical cavity surface-emitting laser (400, 500), comprising:
an optical cavity (223, 323) arranged between a pair of distributed Bragg reflectors (402/404, 502/504);
an active region (217) in the optical cavity;
a current confinement layer (215, 315) arranged on one side of the active layer; and
wherein said current confinement layer includes at least one segregated component material (221, 321) that is electrically conductive.

2. The laser recited in claim 1, wherein said segregated component material is formed on one side (221, 321) of the current confinement layer (215, 315).

3. The laser recited in claim 1 or 2, wherein said segregated component material comprises at least one semimetal material.

4. The laser recited in claim 3, wherein said semimetal material consists essentially of antimony.

5. The laser recited in claim 4, wherein said segregated component material is formed into a layer on one side (221, 321) of the current confinement layer (215, 315).

6. The laser recited in one of the preceding claims wherein said segregated component material is segregated by oxidation of said current confinement layer (215, 315).

7. The laser recited in claim 6, wherein said current confinement layer (215, 315) includes an aperture (220, 320) consisting essentially of AlGaAsSb semiconductor material.

8. The laser recited in claim 7, wherein said AlGaAsSb semiconductor material includes an aluminum composition of at least 90 %.

9. The laser recited in claim 8, wherein said segregated component material is segregated by wet-oxidation of the current confinement layer (215, 315).

10. A vertical cavity surface-emitting laser, comprising:
an InP substrate (406, 506);
an optical cavity (223, 323) positioned over the substrate (406, 506) and between two distributed Bragg reflectors (402/404, 502/504);
wherein said distributed Bragg reflectors (402/404, 502/504) include alternating layers comprising AlGaAsSb and AlAsSb semiconductor materials, respectively.

11. The laser recited in claim 10, wherein said alternating layers comprising AlGaAsSb and AlAsSb semiconductor materials consist essentially of AlGaAsSb and AlAsSb semiconductor materials, respectively.

12. The laser recited in claim 11, wherein said AlGaAsSb and AlAsSb semiconductor materials in one of the distributed Bragg reflectors (402, 404, 502, 504) are undoped.

13. The laser recited in one of claims 10 - 12, wherein each of said distributed Bragg reflectors (402, 404, 502, 504) include less than 31 pairs of layers.

14. The laser recited in one of claims 10 - 13, wherein said optical cavity (223, 323) further includes
an active layer (217) arranged between two spacer layers (213, 214);
said active layer (217) having multiple quantum wells formed from a material selected from the group consisting of InGaAsP/InGaAsP, InAsP/AlInGaAs, and AlIn-GaAs/AlInGaAs; and
said spacer layers (213, 214) formed from a material that is lattice-matched to the active layer (217) and selected from the group consisting of InGaAsP, AlInGaAs, and InP.

15. The laser recited in claim 14, wherein said optical cavity (223, 323) includes a current confinement layer (215, 315) on one side of the active layer and having an aperture (220) consisting essentially of AlGaAsSb semiconductor material.

16. The laser recited in claim 15, wherein an Al composition of said current confinement layer (215, 315) is at least 90 %.

17. The laser recited in claim 15 or 16, wherein said current confinement layer (215, 315) includes a conductive layer (221, 321) consisting essentially of antimony.

18. The laser recited in one of claims 10 - 17, wherein said optical cavity (223, 323) includes at least one contact layer (211, 218) consisting essentially of InP semiconductor material.

19. The laser recited in claim 17, wherein said optical cavity further includes a first contact layer (211, 218) consisting essentially of InP semiconductor material arranged adjacent to the current confining layer (215, 315).

20. The laser recited in claim 19, wherein said InP semiconductor material is p-type.

21. The laser recited in claim 19 or 20, wherein said optical cavity includes a second contact layer (211) on an opposite side of the optical cavity (217) from the at least one contact layer (218), the second contact (211) layer also consisting essentially of InP material.

22. The laser recited in claim 21, wherein said optical cavity further includes a second current confinement layer (315) adjacent to said second contact layer (211), the second current confinement layer (315) also having an aperture consisting essentially of AlGaAsSb semiconductor material and a conductive layer (321) consisting essentially of antimony.

23. The laser recited in claim 22, wherein said second current confinement layer (315) has an aluminum composition that is greater than an aluminum composition of the first current confining (215) layer.

24. A method of fabricating a VCSEL (400, 500) on an InP substrate (406, 506), comprising the steps of:
growing a first distributed Bragg reflector on the substrate (404, 504), said first distributed Bragg reflector (404, 504) having alternating layers consisting essentially of AlGaAsSb and AlAsSb, respectively;
growing a first spacer (213) layer over the first distributed Bragg reflector (404, 504);
growing an active region (217) on the first spacer layer (213);
growing a second spacer layer (214) on the active region (217);
growing a contact layer (218) on the second spacer layer (214), said contact layer (218) consisting essentially of InP; and
growing a second distributed Bragg reflector (402, 502) on the second contact layer.

25. The method recited in claim 24, further comprising the steps of
growing a current confinement layer (215) on the second spacer layer (214), the current confinement layer (215) consisting essentially of AlGaAsSb; and
oxidizing the current confinement layer (215).

26. The laser recited in claim 25, wherein said current confining layer (215) includes an Al content of greater than 90 %.

27. The method recited in one of claims 24 - 26, further comprising the step of:
growing a second contact layer (211) between the first distributed Bragg reflector (504) and the first spacer layer (213), the second contact layer (211) consisting essentially of InP material.

28. The laser recited in claim 27, wherein the first contact layer (218) consists essentially of p-type InP semiconductor material.

29. The laser recited in claim 28, further comprising the step of growing a second current confinement layer (315) consisting essentially of AlGaAsSb semiconductor material between the first distributed Bragg reflector (504) and the second contact layer (211).

30. The laser recited in claim 29, further comprising the step of securing ohmic contacts to the first and second contact layers (218, 211).
